**Europäisches Patentamt**

**European Patent Office**

**Office européen des brevets**

(11) Veröffentlichungsnummer: **0 019 220**
**A1**

## (12) EUROPÄISCHE PATENTANMELDUNG

(21) Anmeldenummer: **80102533.9**

(22) Anmeldetag: **08.05.80**

(51) Int. Cl.³: **H 03 L 7/18**
**H 03 K 5/26**

(30) Priorität: **10.05.79 DE 2918850**

(43) Veröffentlichungstag der Anmeldung:
**26.11.80 Patentblatt 80/24**

(84) Benannte Vertragsstaaten:
**AT CH FR GB LI NL**

(71) Anmelder: **Licentia Patent-Verwaltungs-GmbH**
**Theodor-Stern-Kai 1**
**D-6000 Frankfurt/Main 70(DE)**

(72) Erfinder: **Wetz, Karl, Ing. grad.**
**Mengener Strasse 43**
**D-7486 Scheer-1(DE)**

(74) Vertreter: **Schickle, Gerhard, Dipl.-Ing. et al,**
**Licentia Patent-Verwaltungs-GmbH Theodor-Stern-Kai**
**1**
**D-6000 Frankfurt/Main 70(DE)**

(54) **Lockdetektor für Phasenregelschleifen.**

(57) Zur Erkennung des nichtsynchronen Zustandes einer Phasenregelschleife (PLL) wird am Phasendetektor derselben das Regelsignal zu einem bestimmten Zeitpunkt der Periodendauer $\tau$, vorzugsweise (1/4). $\tau$ oder (3/4). $\tau$, abgefragt. Solange die Schliefe synchronisiert ist, erfolgt die Abfrage immer zum gleichen Zeitpunkt und liefert dann immer den gleichen Ausgangswert "Low" oder "High", wobei Störphasenhübe von bis zu ± 90° keinen störenden Einfluß haben.

FIG. 5

EP 0 019 220 A1

Licentia Patent-Verwaltungs-GmbH     NE2-UL/Bl/wr
Theodor-Stern-Kai 1                     UL 79/41
D-6000 Frankfurt 70

Lockdetektor für Phasenregelschleifen

Die Erfindung betrifft einen Lockdetektor für Phasen-Regelschleifen.

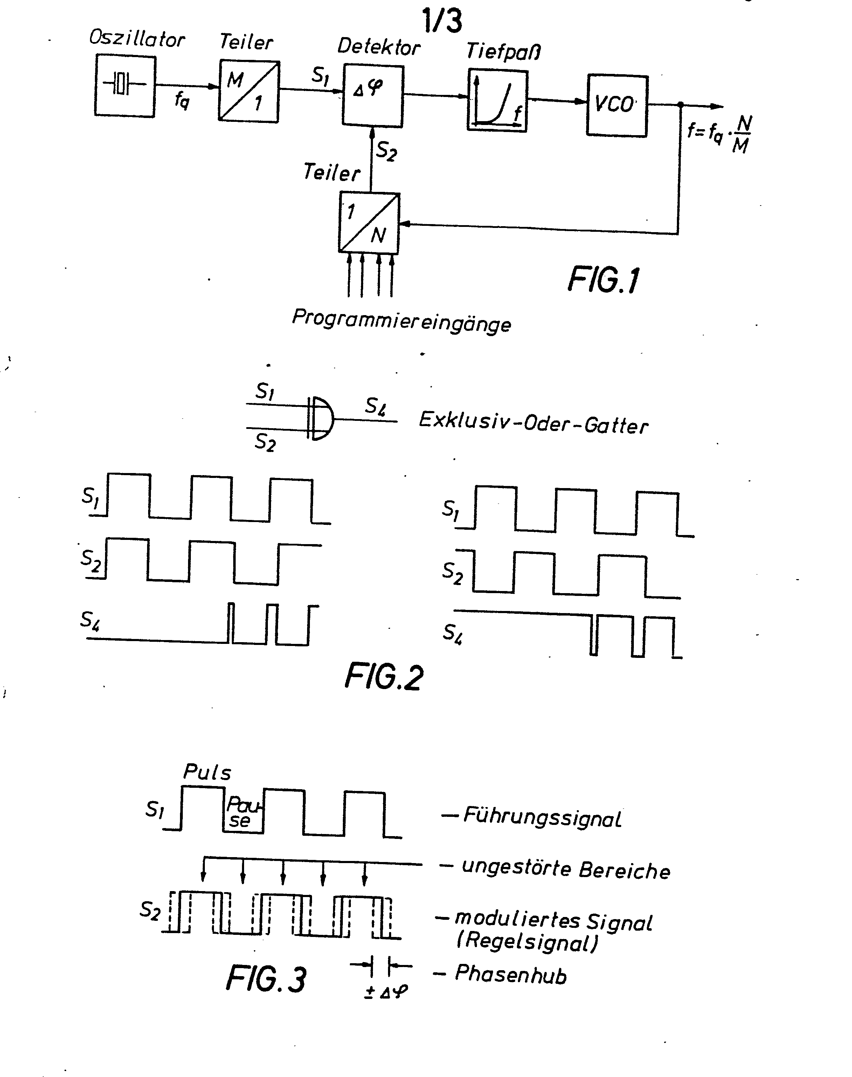

In Phasen-Regelschleifen, auch Phase-Locked-Loop (PLL) genannt, FIG. 1 , ist es oft notwendig, den synchronisierten bzw. nicht synchronisierten Zustand der Schleife zu erkennen. Diese Erkennung geschieht mit Hilfe eines Lockdetektors.

In PLL-Empfängern wird mit dem Lockdetektor der Empfang signalisiert. Bei Funkgeräten wird mit Hilfe des Lockdetektors die Trägeraussendung gesperrt, solange die Regelschleife nicht synchronisiert ist. Mittels des Lockdetektors kann in PLL's die Tiefpaßgrenzfrequenz zur Verkürzung des Fangvorganges umgeschaltet werden.

Der Lockdetektor läßt sich nur in solchen Phasen-Regelschleifen realisieren, welche mit hoher Ringverstärkung (high-gain-loop) arbeiten. Die beiden Eingangssignale, nämlich Führungssignal $S_1$ und Regelsignal $S_2$, am Phasendetektor haben dann im synchronisierten Zustand der Schleife eine

...

konstante Phasendifferenz.

Der Lockdetektor besteht im allgemeinen aus einem Phasendetektor, welchem eine Auswerteschaltung nachgeordnet ist. Bei der Auswertung geht man von der bereits erwähnten Tatsache aus, daß bei "high-gain-loop" im synchronisierten Zustand die Phasendifferenz der beiden Eingangssignale am Phasendetektor der zu überwachenden Regelschleife einen konstanten Wert hat. Dieser zu erwartende feste Wert kennzeichnet somit den synchronisierten Zustand.

Es sind Schaltungen für Lockdetektoren bekannt, bei denen die beiden Eingangssignale, $S_1$ und $S_2$, einem Exklusiv-Oder-Gatter zugeführt werden. Der Ausgang dieses Gatters hat dann bei einer konstanten Phasendifferenz der Eingangssignale von $0^o$ den logischen Pegel "Low", bei konstant $180^o$ den Pegel "High", $S_4$ in FIG. 2. (vgl. Best, Roland, "Theorie und Anwendungen des Phase-Locked Loops", in "Der Elektroniker" Nr. 6/1975 El-14).

Bekannt ist auch eine Lockdetektor-Schaltung mit Multiplizierer (Mischer), der bei der Phasendifferenz von konstant $0^o$ zwischen den beiden Eingangssignalen maximale Ausgangsspannung abgibt. (vgl. Gardner, Floyd M., "Phaselock Techniques", S. 52, New York: John Wiley & Sons, Inc. 1967).

Nachteilig bei diesen Schaltungen ist die Empfindlichkeit gegenüber den auf den Regelkreis einwirkenden Störgrößen. Bereits kleinere Störphasenhübe, hervorgerufen durch Modulation des VCO's oder mechanische Stöße, bewirken ein Ansprechen des Lockdetektors.
Wird der Regelkreis frequenz- bzw. phasenmoduliert, so verschieben sich die Flanken der beiden Eingangssignale des Phasendetektors abhängig vom Phasenhub gegeneinander, FIG. 3. Die oben genannten Lockdetektoren sind dann nur in Verbindung mit einer großen Ansprechverzögerung brauchbar, da sie weder auf Modulation noch auf Phasenstörungen infol-

...

ge mechanischer Beanspruchung reagieren dürfen. Ein schnelles Erkennen des nichtsynchronen Zustandes der Schleife ist somit nicht möglich.

Aufgabe der Erfindung ist es,

einen Lockdetektor mit folgenden Eigenschaften zu erstellen:

a)   Schnelles Ansprechen beim Übergang vom synchronen zum nichtsynchronen Zustand

b)   Wird der Regelkreis frequenz- bzw. phasenmoduliert, oder treten Phasenstörungen infolge mechanischer Beanspruchung auf, so darf bis zu einem gewissen Phasenhub kein Ansprechen des Lockdetektors erfolgen.

Die Erfindung ist im Anspruch 1 beschrieben. Die Unteransprüche beschreiben vorteilhafte Aus- und Weiterbildungen der Erfindung.

Der Nachteil der bisher üblichen, dem Stand der Technik entsprechenden Lockdetektoren resultiert hauptsächlich daraus, daß zur Indikation ausschließlich die Phasendifferenz der beiden Signale, welche am Phasendetektor des PLL's anliegen, ausgewertet wird. Diese Phasendifferenz ist aber keine statische Größe, sondern mehr oder weniger stark von Regelvorgängen des PLL's abhängig.
Alle dem Regelkreis aufgeprägten Störungen, z.B. Modulation, mechanische Schwingungen usw., führen aber zu Regelvorgängen und damit zu Phasendifferenzschwankungen.
Der erfindungsgemäße Lockdetektor umgeht alle diese Nachteile.

Die Erfindung geht aus von der Tatsache, daß bei synchronisierten Schleifen trotz Modulation bis zu einem gewissen Phasenhub ein ungestörter Phasenbereich mit konstantem lo-

...

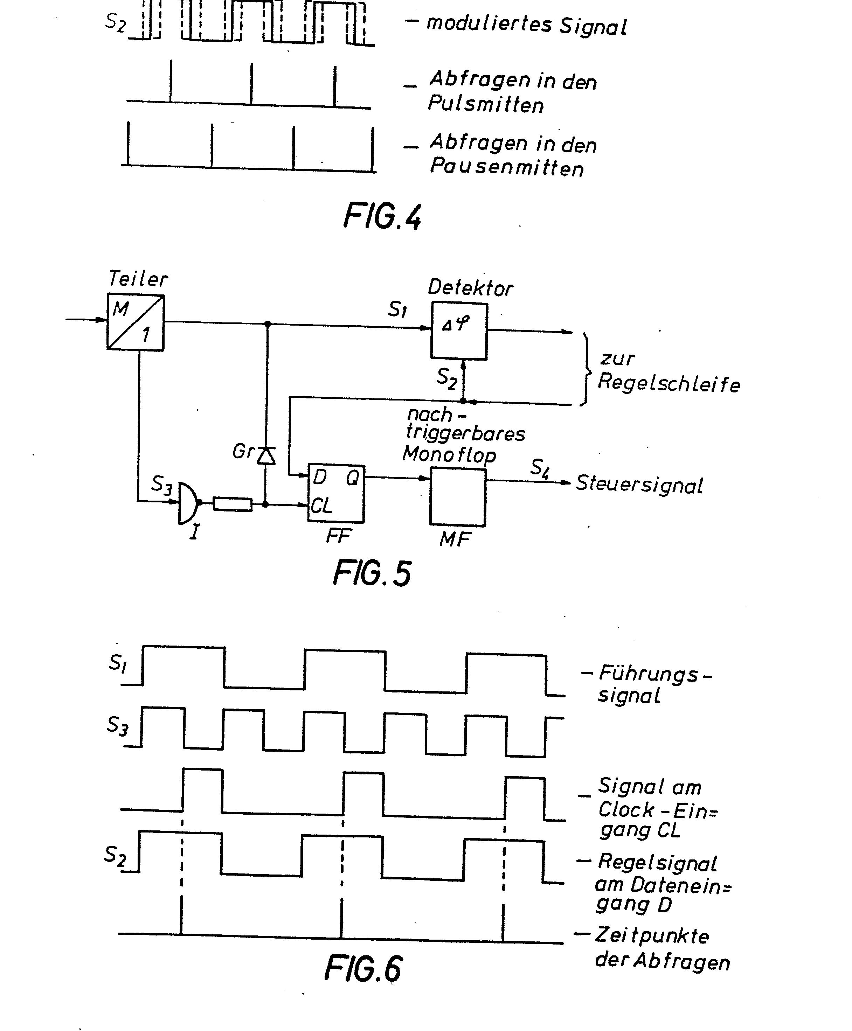

gischen Pegel erhalten bleibt, FIG. 3. Der erfindungsgemäße Lockdetektor fragt innerhalb dieses Bereiches ab, FIG. 4. Der Zeitpunkt der Abfrage wird dabei vom Führungssignal $S_1$ abgeleitet und kann entweder in der Mitte des Pulses oder in der Mitte der Pause liegen. In beiden Fällen ist bei synchronisierten Regelschleifen das Ergebnis der Abfrage eindeutig. Die Abfragedauer ist sehr kurz. Zur Auswertung genügen dadurch schmale ungestörte Bereiche.

Der Lockdetektor reagiert weder auf Modulation noch auf sonstige Phasenstörungen, solange der daraus resultierende Phasenhub den Abfragebereich nicht erreicht.

Geht die Regelschleife in den nichtsynchronen Zustand über, spricht der Lockdetektor praktisch verzögerungsfrei an. Die minimale Ansprechzeit wird durch den Abstand zwischen zwei Abfragen bestimmt.

Ein vorteilhaftes Ausführungsbeispiel des erfindungsgemä-ßen Lockdetektors zeigt FIG. 5. Dabei entsprechen Teiler und Detektor dem Aufbau nach FIG. 1. Der Lockdetektor besteht aus den folgenden Elementen: Einem D-Flip-Flop FF, einem nachtriggerbaren Monoflop MF, einem Inverter I und einer Diode Gr.

Der Funktionsablauf des Lockdetektors ist folgender: Aus dem binären Frequenzteiler M : 1 wird zusätzlich zum Füh-rungssignal $S_1$ mit der Frequenz $f_1$ ein Signal $S_3$ mit der Frequenz $2 \times f_1$ entnommen. Das letztere wird im Inverter I invertiert und auf den Clock-Eingang CL des D-Flip-Flop's FF gegeben. Das D-Flip-Flop bietet den Vorteil, daß mit der Low - High - Flanke des Pulses an CL die Information, die zu diesem Zeitpunkt am Dateneingang D liegt, zum Ausgang Q übertragen wird und dann unabhängig von der Information an D bis zum nächsten Clock-Impuls gespeichert bleibt. Entscheidend für

...

0019220

UL 79/41

die Ausgangsinformation an Q ist somit nur die Information, welche zum Zeitpunkt des Low-High-Überganges des Clock-Pulses am Dateneingang liegt. Alle Zustände zwischen zwei Abfragen haben keinen Einfluß auf den Ausgang Q.

Wird an D das Regelsignal $S_2$ gegeben, so finden mit den entsprechenden Flanken des Pulses an CL Abfragen über den jeweiligen Zustand des Signals $S_2$ statt, FIG. 6. Mit der Diode Gr wird jede zweite Abfrage unterdrückt, um im synchronisierten Zustand einen konstanten logischen Pegel am Ausgang Q zu erhalten.

Ist der Regelkreis synchronisiert, so hat Q dauernd den logischen Pegel "High".

Wird durch Ändern des Teilerfaktors N in der Schleife, FIG. 1, ein Frequenzwechsel vorgenommen, so läuft während des Fangvorgangs der Schleife das Signal $S_2$ vom Signal $S_1$ aus gesehen durch. Der Ausgang Q des D-Flip-Flops nach FIG. 5, hat nun im Mittel nach jeder Abfrage einen anderen logischen Zustand, FIG. 7. Mit dieser Pulsfolge wird zur Überbrückung der Pausen zwischen den Abfragen ein nachtriggerbares Monoflop MF angesprochen und so lange nachgesetzt, bis der Fangvorgang abgeschlossen ist und die Abfragen wieder einen konstanten Pegel an Q ergeben. Die Rücksetzzeit des Monoflops muß größer sein als der Abstand zwischen den ankommenden Triggerpulsen.

Am Ausgang des Monoflops MF erscheint ein Steuersignal, das der Dauer des nichtsynchronen Zustandes der Schleife entspricht.

Wie schon erwähnt, ist die Ansprechzeit dieses erfindungsgemäßen Lockdetektors sehr kurz. Für die Praxis empfiehlt es sich jedoch, für eine weitere Verbesserung der Störsicherheit die Ansprechgeschwindigkeit nicht voll auszunutzen, sondern eine Integration über mehrere Abfragezyklen zu machen. Bei genügend hoher Abfragefrequenz bringt dies in der Praxis keine wesentliche Beeinträchtigung der Vorteile dieses Lockdetektors.

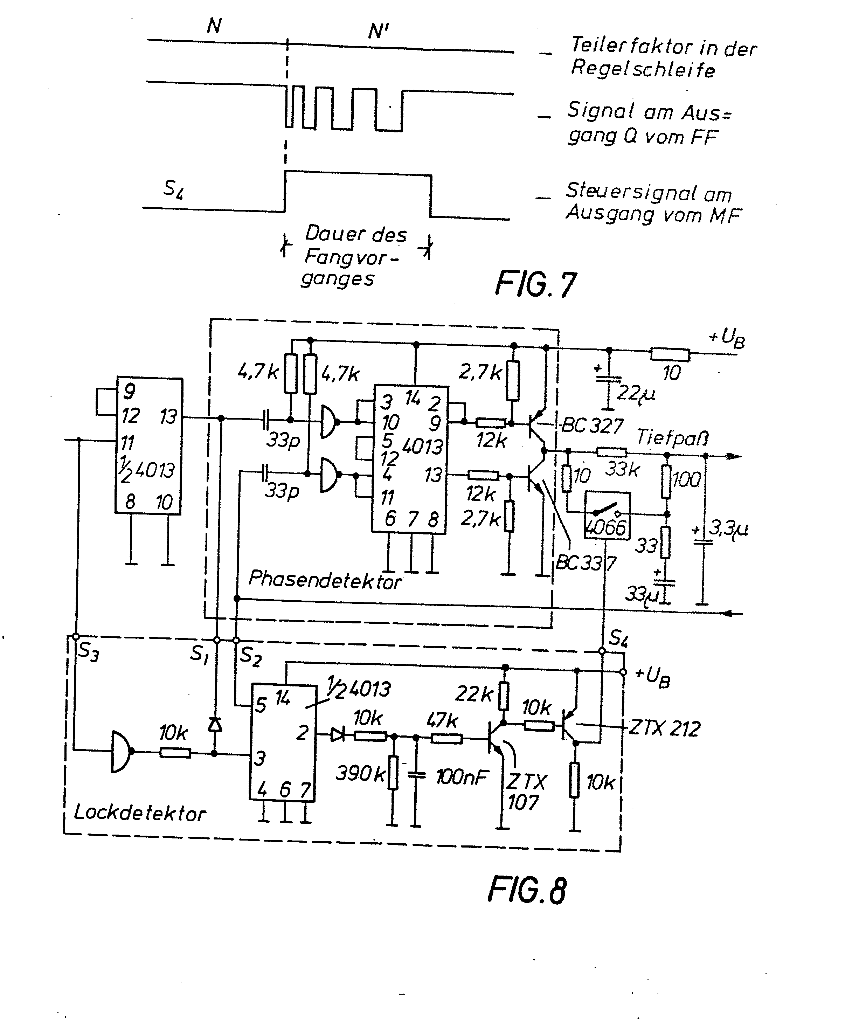

Eine praktisch ausgeführte Schaltung des erfindungsgemäßen Lockdetektors zeigt FIG. 8.

- 6 -

Licentia Patent-Verwaltungs-GmbH          NE2-UL/Bl/wr
Theodor-Stern-Kai 1                        UL 79/41
D-6000 Frankfurt 70

Patentansprüche

1. Lockdetektor für Phasenregelschleifen, <u>dadurch gekenn-
zeichnet</u>, daß zur Erkennung des nichtsynchronen Zustandes
der zu überwachenden Regelschleife am Phasendetektor derselben das Regelsignal ($S_2$) zu einem bestimmten Zeitpunkt
der Periodendauer $\tau$, vorzugsweise $(1/4) \cdot \tau$ oder $(3/4) \cdot \tau$,
abgefragt wird (FIG. 4).

2. Lockdetektor nach Anspruch 1, dadurch gekennzeichnet,
daß dem binären Frequenzteiler M : 1 der Phasenregelschleife außer dem Führungssignal ($S_1$) der Frequenz $f_1$ ein Signal ($S_3$) der Frequenz $2f_1$ entnommen, in einem Inverter (I)
invertiert und auf den Clockeingang (CL) eines D-Flip-Flops
(FF) gegeben ist,
daß dem Dateneingang (D) des letzteren das Regelsignal ($S_2$)
zugeführt ist,
und daß mittels einer Diode (Gr) jedes zweite Signal ($S_3$)
unterdrückt ist (FIG. 5, 6).

3. Lockdetektor nach Anspruch 1 oder 2, dadurch gekennzeichnet, daß dem eigentlichen Lockdetektor ein nachtriggerbares

...

0019220

Monoflop (MF) mit geringer Ansprechverzögerung nachgeschaltet ist, welches ein Ansprechen des Lockdetektors bei großen vorübergehenden kurzen Phasenstörungen verhindert (FIG . 5).

...

0019220

Oszillator  Teiler  Detektor  Tiefpaß

$f = f_q \cdot \dfrac{N}{M}$

Teiler

FIG.1

Programmiereingänge

$S_1$  $S_4$  Exklusiv-Oder-Gatter

$S_2$

$S_1$

$S_2$

$S_4$

$S_1$

$S_2$

$S_4$

FIG.2

Puls

$S_1$  Pause

— Führungssignal

— ungestörte Bereiche

$S_2$

— moduliertes Signal
(Regelsignal)

FIG.3  $\pm \Delta\varphi$  — Phasenhub

0019220

2/3

$S_2$ — moduliertes Signal

— Abfragen in den Pulsmitten

— Abfragen in den Pausenmitten

FIG.4

Teiler    Detektor

$M/1$    $S_1$    $\Delta\varphi$

$S_2$    } zur Regelschleife

nach-triggerbares Monoflop

Gr

$S_3$    $I$    $D$ $Q$    $S_4$ → Steuersignal
$CL$
$FF$    $MF$

FIG.5

$S_1$ — Führungssignal

$S_3$

— Signal am Clock-Ein= gang CL

$S_2$ — Regelsignal am Datenein= gang D

— Zeitpunkte der Abfragen

FIG.6

**FIG.7**

Teilerfaktor in der Regelschleife

Signal am Ausgang Q vom FF

Steuersignal am Ausgang vom MF

**FIG.8**

0019220

**Europäisches Patentamt**

## EUROPÄISCHER RECHERCHENBERICHT

Nummer der Anmeldung

EP 80 10 2533

| EINSCHLÄGIGE DOKUMENTE | | | KLASSIFIKATION DER ANMELDUNG (Int Cl) |
|---|---|---|---|
| Kategorie | Kennzeichnung des Dokuments mit Angabe, soweit erforderlich, der maßgeblichen Teile | betrifft Anspruch | H 03 L 7/18<br>H 03 K 5/26 |
| | US - A - 4 151 463 (KIBLER)<br> * Spalte 1, Zeile 50 - Spalte 4, Zeile 66; Figur 1 *<br>-- | 1,2 | |
| | US - A - 3 982 190 (SCHAEFER)<br> * Spalte 1, Zeile 44 - Spalte 3, Zeile 6; Figuren 1,2 *<br>-- | 1,2 | |
| | US - A - 3 988 696 (SHARPE)<br> * Spalte 1, Zeile 29 - Spalte 4, Zeile 6; Figur 1 *<br>-- | 1-3 | **RECHERCHIERTE SACHGEBIETE (Int Cl ³)**<br><br>H 03 L 7/18<br>      7/22<br>H 03 K 5/26<br>H 03 C 3/09<br>H 03 L 7/06<br>      7/08<br>      7/10<br>      7/12 |
| | ELECTRONICS, Band 48, Nr. 11, 29. Mai 1975, Seite 106<br>New York, U.S.A.<br>R.P. LECK: "Logic gates and LED indicate phase lock"<br> * Seite 106 *<br>-- | 1 | |
| | FR - A - 2 265 214 (SIEMENS)<br> * Seite 2, Zeile 1 - Seite 4, Zeile 31; Figur 2 *<br>-- | 1,3 | |
| | DE - A - 2 716 044 (LICENTIA)<br> * Seite 3, Zeile 1 - Seite 6, Zeile 8; Figur 1 *<br>---- | 1-3 | **KATEGORIE DER GENANNTEN DOKUMENTE**<br><br>X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze<br>E: kollidierende Anmeldung<br>D: in der Anmeldung angeführtes Dokument<br>L: aus andern Gründen angeführtes Dokument<br>&: Mitglied der gleichen Patentfamilie, übereinstimmendes Dokument |

X  Der vorliegende Recherchenbericht wurde für alle Patentansprüche erstellt

| Recherchenort. | Abschlußdatum der Recherche | Prüfer |
|---|---|---|
| Den Haag | 18-08-1980 | DHONDT |

EPA form 1503.1  06.78